(19) Europäisches Patentamt
European Patent Office
Office européen des brevets

(11) EP 3 627 538 A1

(12) EUROPEAN PATENT APPLICATION
published in accordance with Art. 153(4) EPC

(43) Date of publication:
25.03.2020 Bulletin 2020/13

(51) Int Cl.:
H01L 21/3065 (2006.01)    H01L 21/768 (2006.01)
H01L 23/532 (2006.01)

(21) Application number: 18801753.7

(22) Date of filing: 09.05.2018

(86) International application number:
PCT/JP2018/017995

(87) International publication number:
WO 2018/212045 (22.11.2018 Gazette 2018/47)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 16.05.2017 JP 2017097569

(71) Applicants:
• Tokyo Electron Limited
  Tokyo 107-6325 (JP)
• L'AIR LIQUIDE, Société Anonyme pour l'Etude
  et l'Exploitation des Procédés Georges Claude
  75007 Paris (FR)
• Université d'Orléans
  45067 Orléans Cedex 2 (FR)
• Centre National de la Recherche Scientifique
  75016 Paris (FR)

(72) Inventors:
• TAHARA Shigeru
  Kurokawa-gun
  Miyagi 981-3629 (JP)
• URABE Keiichiro
  Tsukuba-shi
  Ibaraki 300-4247 (JP)
• SHEN Peng
  Tsukuba-shi
  Ibaraki 300-4247 (JP)
• DUSSARRAT Christian
  Tsukuba-shi
  Ibaraki 300-4247 (JP)
• DE MARNEFFE Jean-Francois
  3001 Leuven (BE)
• DUSSART Remi
  45750 Saint-Pryv -Saint-Mesmin (FR)
• TILLOCHER Thomas
  45100 Orleans (FR)

(74) Representative: Jacob, Reuben Ellis et al
Maucher Jenkins
26 Caxton Street
London SW1H 0RJ (GB)

(54) METHOD FOR ETCHING POROUS FILM

(57)    A method of an embodiment includes (i) a step of supplying a first gas to a chamber, wherein the first gas is perfluorotetraglyme gas, and (ii) a step of generating plasma of a second gas for etching of a porous film in order to etch the porous film at the same time as the step of supplying a first gas or after the step of supplying a first gas. Partial pressure of the first gas in the chamber or pressure of the first gas in the chamber when only the first gas is supplied to the chamber is higher than critical pressure causing capillary condensation of the first gas in the porous film and is lower than saturated vapor pressure of the first gas at a temperature of the workpiece during execution of the step of supplying a first gas.

Fig.1

**Description**

**Technical Field**

An embodiment of the present disclosure relates to a method of etching a porous film.

**Background Art**

In an electronic device such as a semiconductor device, a porous film may be used. As the porous film, for example, a film formed of a low-dielectric constant material, such as a SiOCH film is used. When manufacturing such an electronic device, a fine pattern formed in photoresist by lithography is transferred to a film such as a TiN film, a $SiO_2$ film, and a $Si_3N_4$ film by plasma etching as necessary, thereby forming a hard mask. Then, processing of transferring the pattern to a porous film is performed by plasma etching.

In plasma etching of a porous film, radical is generated by exciting an etching gas in a chamber of a plasma processing apparatus. However, the radical may penetrate into a pore of the porous film to cause damage to the porous film. Therefore, a technology of restraining radical from penetrating into a porous film is required.

Patent Literature 1 (i.e. Japanese Patent Application Laid-Open Publication No. 2016-207768) discloses a technology of restraining radical from penetrating into a porous film. In the technology disclosed in Patent Literature 1, a fluorocarbon gas such as $C_6F_6$ gas and $C_7F_8$ gas, a hydrocarbon gas, or an oxygen-containing hydrocarbon gas is liquefied in a porous film due to capillary condensation, thereby becoming liquid. Due to the liquid generated as described above, radical is restrained from penetrating into the porous film at the time of plasma etching.

**Citation List**

**Patent Literature**

Patent Literature 1: Japanese Patent Application Laid-Open Publication No. 2016-207768

**Summary of Invention**

**Technical Problem**

In a case where a time during which the above-described liquid is retained in a porous film is short, the time for plasma etching cannot be taken for a sufficiently long time. Therefore, in a case where the time during which the liquid is retained in the porous film is short, it is necessary to perform many times of repetition of supplying a gas causing capillary condensation thereof in the porous film and plasma etching for a short time. As a result, a throughput of etching the porous film deteriorates. From such a background, it is required to increase the time during which liquid generated due to capillary condensation is retained in the porous film.

**Solution to Problem**

In one aspect, there is provided a method of etching a porous film. The method is performed in a state where a workpiece is placed on a stage provided in a chamber of a plasma processing apparatus. The workpiece has the porous film and a mask. The mask is provided on the porous film and provides an opening exposing the porous film partially. The method includes (i) a step of supplying a first gas to the chamber, wherein the first gas is a gas consisting of perfluorotetraglyme ($C_{10}F_{20}O_5$), and (ii) a step of generating plasma of a second gas for etching the porous film, to etch the porous film at the same time as the step of supplying a first gas or after the step of supplying a first gas. Partial pressure of the first gas in the chamber or pressure of the first gas in the chamber when only the first gas is supplied to the chamber is higher than critical pressure causing capillary condensation of the first gas in the porous film and lower than saturated vapor pressure of the first gas at a temperature of the workpiece during execution of the step of supplying a first gas.

When the first gas, that is, the perfluorotetraglyme gas is condensed in the porous film and becomes liquid, the liquid is retained in the porous film for a comparatively long time. Therefore, according to the method, a throughput of etching a porous film is improved. In addition, the perfluorotetraglyme is a molecule including a relatively large number of oxygen atoms. Accordingly, during etching, fragments containing oxygen are generated, but a simple substance of an oxygen atom (oxygen radical) is restrained from being generated. Therefore, the quantity of reaction products containing carbon generated by etching can be reduced, without supplying a large quantity of oxygen gas or the like. Thus, damage of the porous film is reduced.

In one embodiment, in the step of supplying a first gas, a mixed gas including the first gas and the second gas may be supplied to the chamber. In the step of generating plasma of a second gas, plasma of the mixed gas may be generated in the chamber. That is, in a state where the first gas and the second gas are supplied at the same time, plasma of the mixed gas including the first gas and the second gas may be generated. In one embodiment, in the step of supplying a first gas and the step of generating plasma of a second gas, the temperature of the workpiece may be set to a temperature not less than -50°C and not more than -30°C, the partial pressure of the first gas may be set to 0.4 Pa (3 mTorr) or higher, and total pressure of gas in the chamber may be set to 3.333 Pa (25 mTorr) or lower. In one embodiment, in the step of generating plasma of a second gas, a power of at least one of a first radio frequency wave for generating the plasma and a second radio frequency wave for attracting ion to the workpiece may be increased and decreased alternately. For example, ON and OFF of at least one of the first radio frequency wave and the second radio frequency wave may be switched alternately.

In one embodiment, the step of supplying a first gas and the step of generating plasma of a second gas are alternately performed. The method of the embodiment further includes, between the step of supplying a first gas and the step of generating plasma of a second gas, a step of supplying the second gas to the chamber without generating plasma. In one embodiment, in the step of supplying a first gas and the step of generating plasma of a second gas, the temperature of the workpiece is set to a temperature not less than -50°C and not more than -30°C. In the step of supplying a first gas, the partial pressure of the first gas in the chamber or the pressure of the first gas in the chamber when only the first gas is supplied to the chamber is set to 0.4 Pa (3 mTorr) or higher.

In one embodiment, the method further includes a step of removing liquid in the porous film generated from the first gas, after the porous film is etched. In the step of removing liquid, the workpiece is heated such that pressure of the liquid becomes lower than the critical pressure under a vacuumed environment.

In one embodiment, the porous film may be a low-dielectric constant film containing silicon, oxygen, carbon, and hydrogen. In one embodiment, the second gas may include nitrogen trifluoride ($NF_3$) gas.

**Advantageous Effects of Invention**

As described above, in etching a porous film, the time during which liquid is retained in a porous film can be increased.

**Brief Description of Drawings**

FIG. 1 is a flow chart illustrating a method of etching a porous film according to one embodiment.
FIG. 2 is a partially enlarged cross-sectional view of an example of a workpiece.
FIG. 3 is a view illustrating a processing system including a plasma processing apparatus according to one embodiment.
FIG. 4 is a view schematically illustrating a plasma processing apparatus according to one embodiment.
FIG. 5 is a timing chart related to the method illustrated in FIG. 1.
FIG. 6 is a partially enlarged cross-sectional view of a workpiece obtained during execution of the method illustrated in FIG. 1.
FIG. 7 is a partially enlarged cross-sectional view of a workpiece obtained during execution of the method illustrated in FIG. 1.
FIG. 8 is a partially enlarged cross-sectional view of a workpiece obtained by executing the method illustrated in FIG. 1.
FIG. 9 is a flow chart illustrating a method of etching a porous film according to another embodiment.
FIG. 10 is a timing chart related to the method illustrated in FIG 9.
FIG. 11 is a graph illustrating a chronological change of a refractive index of a porous film.
FIG. 12 is a view illustrating dimensions measured in a second experiment and a third experiment.
FIG. 13 is a graph illustrating a relationship between the temperature of a porous film and the refractive index of the porous film.

**Description of Embodiments**

Hereinafter, various embodiments will be described in detail with reference to the drawings. In the drawing, the same or equivalent portions are denoted by the same reference symbols.

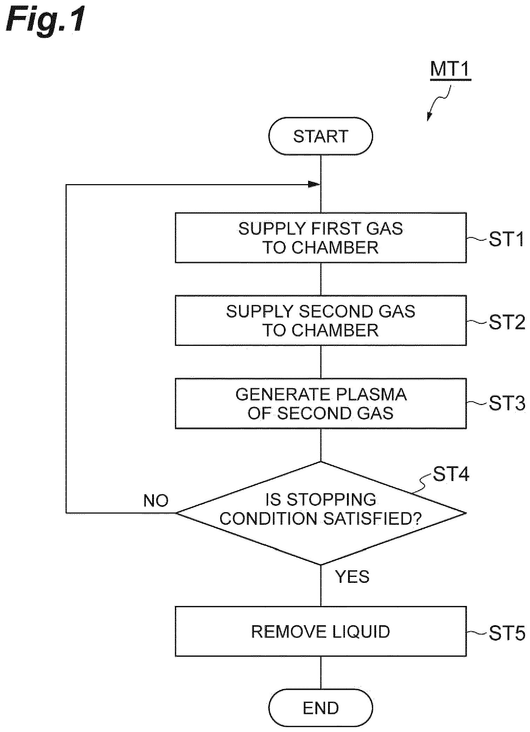

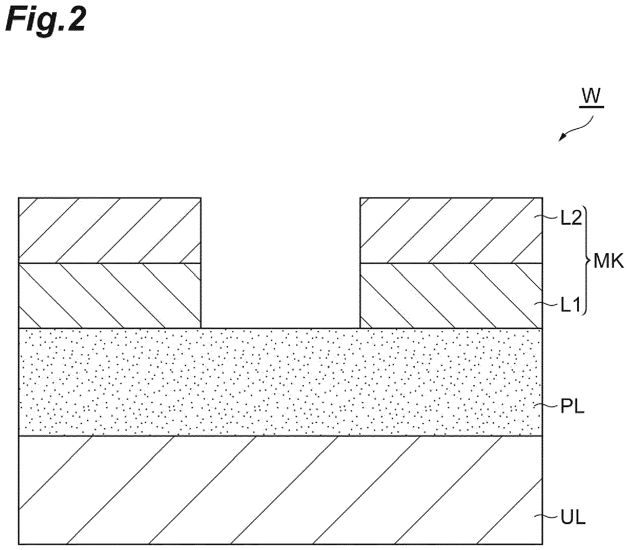

FIG. 1 is a flow chart illustrating a method of etching a porous film according to one embodiment. A method MT1 illustrated in FIG. 1 is the method of etching the porous film of a workpiece while the porous film is protected by liquid based on a first gas. FIG. 2 is a partially enlarged cross-sectional view of an example of a workpiece. As illustrated in FIG 2, a workpiece W includes an underlying layer UL, a porous film PL, and a mask MK. For example, the workpiece W can have a substantial disk shape.

The porous film PL is provided on the underlying layer UL. Multiple pores are formed in the porous film PL. The pores have an average width of several nm, for example, an average width within a range from 1 nm to 2 nm. The average width is obtained from the average value of the maximum widths of the pores. The porous film PL is a film formed of a low-dielectric constant material. The porous film PL is a low-dielectric constant film. For example, the porous film PL may be a film containing silicon, oxygen, carbon, and hydrogen, that is, a SiOCH film. The porous film PL may be formed by a film forming method such as a chemical vapor growth method and a spin film forming method.

The mask MK is provided on the porous film PL. In an example, the mask MK may include a first layer L1 and a second layer L2. For example, the first layer L1 is a silicon oxide film. For example, the second layer L2 is a TiN film. The mask MK provides opening. That is, a pattern to be transferred to the porous film PL is formed in the mask MK. The mask MK may be formed by using a lithography technology and plasma etching.

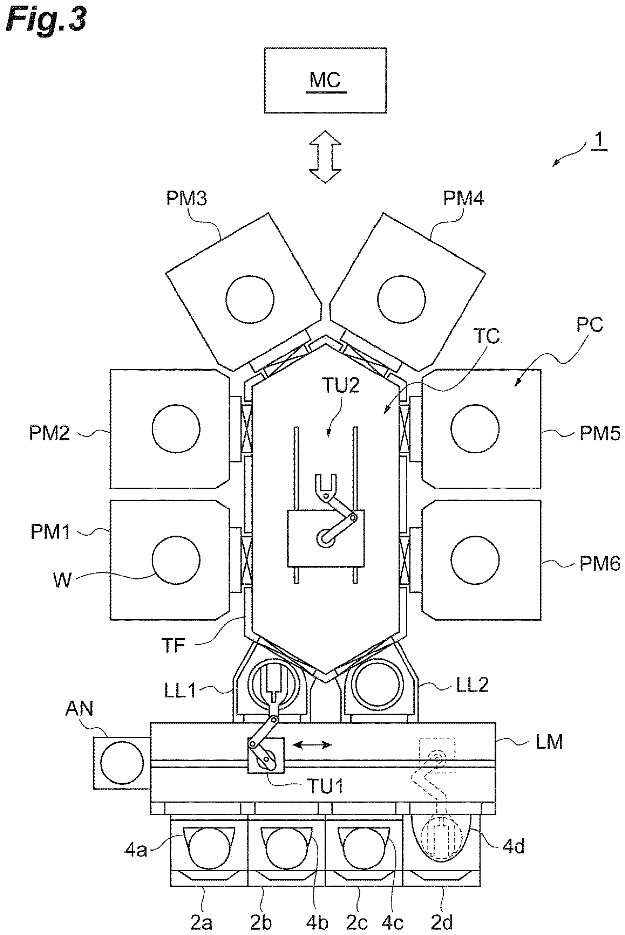

In the method MT1, a porous film is etched in a state where the workpiece W is accommodated in a chamber of a plasma processing apparatus. FIG. 3 is a view illustrating a processing system including the plasma processing apparatus according to one embodiment. A processing system 1 illustrated in FIG. 3 can be used in performing the method MT1. The processing system 1 includes bases 2a to 2d, containers 4a to 4d, a loader module LM, an aligner AN, load lock modules LL1 and LL2, process modules PM1 to PM6, a transfer module TF, and a controller MC. The number of the bases, the number of the containers, the number of the load lock modules in the processing system 1 may be an arbitrary number of one or more. In addition, the number of the process modules may be an arbitrary number of two or more.

The bases 2a to 2d are arranged along one edge of the loader module LM. The containers 4a to 4d are mounted on the bases 2a to 2d, respectively. For example, each of the containers 4a to 4d is a container called a front opening unified pod (FOUP). Each of the containers 4a to 4d is configured to accommodate the workpiece W therein.

The loader module LM provides a chamber. The pressure of the chamber provided by the loader module LM is set to atmospheric pressure. A transfer unit TU1 is provided in the chamber of the loader module LM. For example, the transfer unit TU1 is an articulated robot and is controlled by the controller MC. The transfer unit TU1 is configured to transfer the workpiece W between each of the containers 4a to 4d and the aligner AN, between the aligner AN and each of the load lock modules LL1 and LL2, and between each of the load lock modules LL1 and LL2 and each of the containers 4a to 4d. The aligner AN is connected to the loader module LM. The aligner AN is configured to adjust the position (calibrate the position) of the workpiece W.

Each of the load lock module LL1 and the load lock module LL2 is provided between the loader module LM and the transfer module TF. Each of the load lock module LL1 and the load lock module LL2 provides a preliminary depressurization chamber.

The transfer module TF is connected to the load lock module LL1 and the load lock module LL2 via gate valves. The transfer module TF provides a transfer chamber TC capable of being depressurized. A transfer unit TU2 is provided in the transfer chamber TC. For example, the transfer unit TU2 is an articulated robot and is controlled by the controller MC. The transfer unit TU2 is configured to transfer the workpiece W between each of the load lock modules LL 1 and LL2 and each of the process modules PM1 to PM6, and between two arbitrary process modules among the process modules PM1 to PM6.

Each of the process modules PM1 to PM6 is a processing apparatus configured to perform dedicated substrate treatment. Each of the process modules PM1 to PM6 provides a chamber. The chamber of each of the process modules PM1 to PM6 is connected to the chamber of the transfer module TF via a gate valve. One process module among the process modules PM1 to PM6 is a plasma processing apparatus. Another process module among the process modules PM1 to PM6 is a heat treatment apparatus. In the following description, the process module PM5 is set as the heat treatment apparatus. As described below, the heat treatment apparatus is configured to heat the workpiece W in a chamber PC thereof after etching the porous film PL, thereby vaporizing liquid in the porous film PL and discharging gas generated from the liquid.

The controller MC may be a computer device including a processor, a storage device such as a memory, a display device such as a display, an input/output device such as a keyboard and a mouse, an input/output interface for a control signal, and a communication device. The storage device stores a control program and recipe data. The processor operates in accordance with the control program and the recipe data and transmits the control signal to each part of the processing system 1, thereby controlling each part of the processing system 1.

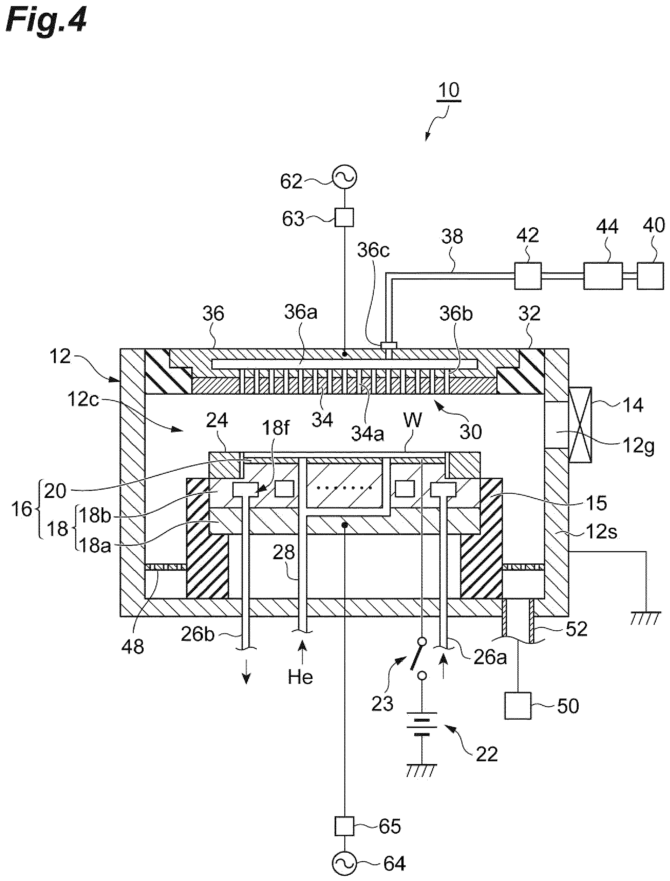

FIG. 4 is a view schematically illustrating the plasma processing apparatus according to one embodiment. FIG. 4 illustrates the plasma processing apparatus according to one embodiment in a state of being partially broken. A plasma processing apparatus 10 illustrated in FIG. 4 can be used as the process module of the processing system 1. The plasma processing apparatus 10 is a capacitive coupling-type plasma etching apparatus.

The plasma processing apparatus 10 includes a chamber body 12. The chamber body 12 has a substantially cylindrical shape. The chamber body 12 provides an inner space thereof as a chamber 12c. A plasma resistant coat is formed on an inner wall surface of the chamber body 12. The coat may be an alumite film or a film formed of yttrium oxide. The chamber body 12 is grounded. Opening 12g is formed in a side wall of the chamber body 12. When the workpiece W is transferred into the chamber 12c from the outside of the chamber body 12, and when the workpiece W is transferred out of the chamber body 12 from the chamber 12c, the workpiece W passes through the opening 12g. In order to open and close the opening 12g, a gate valve 14 is attached to the side wall of the chamber body 12.

A support 15 is provided on the bottom portion of the chamber body 12. The support 15 has a substantially cylindrical shape. For example, the support 15 is formed of an insulating material. The support 15 extends upward from the bottom portion of the chamber body 12 inside the chamber 12c. A stage 16 is provided in the chamber 12c. The stage 16 is supported by the support 15.

The stage 16 is configured to hold the workpiece W placed thereon. The stage 16 has a lower electrode 18 and an electrostatic chuck 20. The lower electrode 18 includes a first plate 18a and a second plate 18b. For example, the first plate 18a and the second plate 18b are formed of metal such as aluminum and have substantial disk shapes. The second plate 18b is provided on the first plate 18a and is electrically connected to the first plate 18a.

The electrostatic chuck 20 is provided on the second plate 18b. The electrostatic chuck 20 has an insulating layer and a film-shaped electrode provided inside the insulating layer. A DC power source 22 is electrically connected to the electrode of the electrostatic chuck 20 via a switch 23. A DC voltage is applied to the electrode of the electrostatic chuck 20 from the DC power source 22. When the DC voltage is applied to the electrode of the electrostatic chuck 20, the electrostatic chuck 20 generates electrostatic attractive force to attract the workpiece W to the electrostatic chuck 20, thereby holding the workpiece W. A heater may be built inside the electrostatic chuck 20, and a heater power source provided outside the chamber body 12 may be connected to the heater.

A focus ring 24 is provided on a circumferential edge portion of the second plate 18b. The focus ring 24 is a substantially ring-shaped plate. The focus ring 24 is disposed to surround the edge of the workpiece W and the electrostatic chuck 20. The focus ring 24 is provided in order to improve uniformity of etching. For example, the focus ring 24 may be formed of a material such as silicon and quartz.

A flow channel 18f is provided in the second plate 18b. A refrigerant is supplied to the flow channel 18f via a pipe 26a from a chiller unit provided outside the chamber body 12. The refrigerant supplied to the flow channel 18f returns to the chiller unit via a pipe 26b. That is, the refrigerant circulates between the flow channel 18f and the chiller unit. The temperature of the stage 16 (or the electrostatic chuck 20) and the temperature of the workpiece W are adjusted by controlling the temperature of the refrigerant. As the refrigerant, a general refrigerant which can set the temperature of the workpiece W to a temperature of -60°C or higher, for example, a temperature not less than -50°C and not more than -30°C is used. Such a refrigerant includes Galden (registered trademark), for example.

A gas supply line 28 is provided in the plasma processing apparatus 10. The gas supply line 28 supplies a heat transfer gas, for example, He gas from a heat transfer gas supply mechanism to a space between the top surface of the electrostatic chuck 20 and the back surface of the workpiece W.

The plasma processing apparatus 10 further includes an upper electrode 30. The upper electrode 30 is provided above the stage 16. The upper electrode 30 is supported by an upper portion of the chamber body 12 via a member 32. The upper electrode 30 can include an electrode plate 34 and a support 36. The bottom surface of the electrode plate 34 faces the chamber 12c. A plurality of gas outlet holes 34a are provided in the electrode plate 34. The electrode plate 34 can be formed of a material such as silicon and oxide silicon.

The support 36 detachably supports the electrode plate 34 and is formed of a conductive material such as aluminum. A gas diffusion chamber 36a is provided inside the support 36. A plurality of gas flow holes 36b communicating with the gas outlet holes 34a extend downward from the gas diffusion chamber 36a. A gas introduction port 36c introducing gas to the gas diffusion chamber 36a is formed in the support 36. A gas supply pipe 38 is connected to the gas introduction port 36c.

A gas source group 40 is connected to the gas supply pipe 38 via a valve group 42 and a flow rate controller group 44. The gas source group 40 includes a plurality of gas sources. The plurality of gas sources include a source of the first gas and one or more sources of a second gas. The first gas is gas causing capillary condensation thereof in the porous film PL. The second gas is a gas for etching the porous film PL. The plurality of gas sources may include a source of a gas other than these gases.

The valve group 42 includes a plurality of valves, and the flow rate controller group 44 includes a plurality of flow rate controllers such as a massflow controller and a pressure control-type flow rate controller. The plurality of gas sources of the gas source group 40 are connected to the gas supply pipe 38 via the corresponding valves in the valve group 42 and the corresponding flow rate controllers in the flow rate controller group 44, respectively.

A baffle member 48 is provided between the support 15 and the side wall of the chamber body 12. For example, the baffle member 48 is a plate-shaped member and may be formed by coating a surface of an aluminum base material with ceramics such as $Y_2O_3$. A plurality of holes penetrating the baffle member 48 are formed in the baffle member 48. Below the baffle member 48, a gas discharging apparatus 50 is connected to the bottom portion of the chamber body 12 via a discharge pipe 52. The gas discharging apparatus 50 has a pressure controller such as a pressure adjustment valve, and a vacuum pump such as a turbomolecular pump and can depressurize the chamber 12c to desired pressure.

The plasma processing apparatus 10 further includes a first radio frequency power source 62 and a second radio frequency power source 64. The first radio frequency power source 62 is a power source generating a first radio frequency wave (radio frequency electrical energy) for generating plasma. For example, the first radio frequency wave has a frequency within a range from 27 to 100 MHz. The first radio frequency power source 62 is connected to the upper electrode 30 via an impedance matcher 63. The impedance matcher 63 has a circuit for matching output impedance of the first radio frequency power source 62 and impedance on a load side (the upper electrode 30 side). The first radio frequency power source 62 may be connected to the lower electrode 18 via the impedance matcher 63.

The second radio frequency power source 64 is a power source generating a second radio frequency wave (radio frequency electrical energy) for attracting ion to the workpiece W. For example, the second radio frequency wave has a frequency within a range from 400 kHz to 13.56 MHz. The second radio frequency power source 64 is connected to the lower electrode 18 via an impedance matcher 65. The impedance matcher 65 has a circuit for matching output impedance of the second radio frequency power source 64 and impedance on a load side (the lower electrode 18 side).

Hereinafter, the method MT1 will be described in connection with a case where the method MT1 is applied to the workpiece W, using the processing system 1 having the plasma processing apparatus 10 as one process module. However, the method MT1 can be performed by using an arbitrary plasma processing apparatus or an arbitrary processing system. In addition, the method MT1 can be applied to an arbitrary workpiece having a porous film.

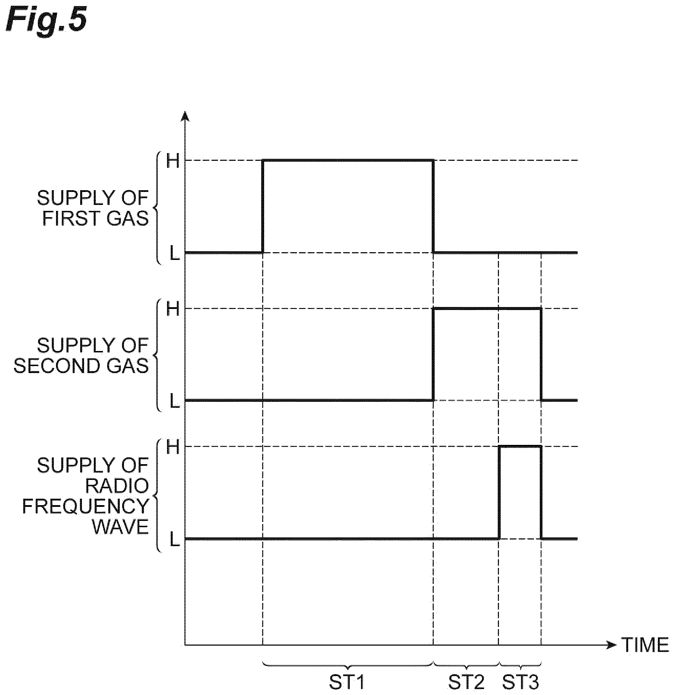

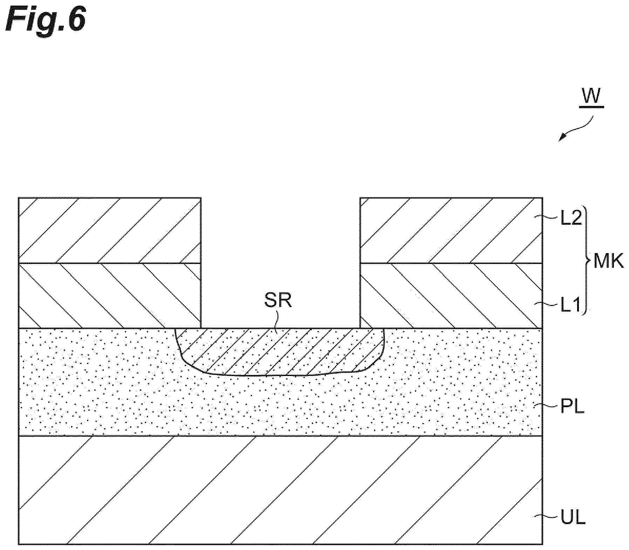

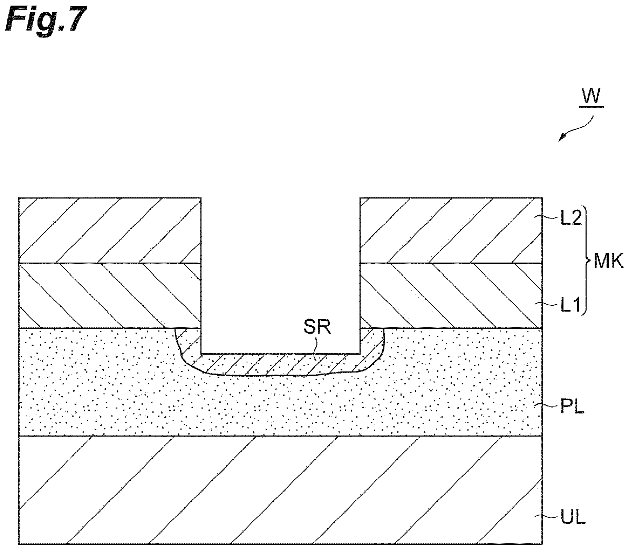

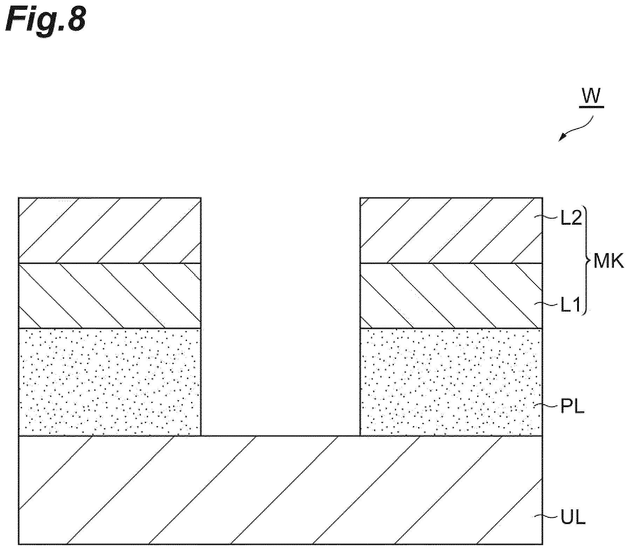

The following description will be given with reference to FIGS. 5 to 8, in addition to FIG. 1. FIG. 5 is a timing chart related to the method illustrated in FIG. 1. In FIG. 5, the horizontal axis indicates the time. In the timing chart related to supply of the first gas in FIG. 5, a high level (in the diagram, the level indicated by "H") indicates that the first gas is supplied to the chamber 12c, and a low level (in the diagram, the level indicated by "L") indicates that the first gas is not supplied to the chamber 12c. In addition, in the timing chart related to supply of the second gas in FIG. 5, the high level (in the diagram, the level indicated by "H") indicates that the second gas is supplied to the chamber 12c, and the low level (in the diagram, the level indicated by "L") indicates that the second gas is not supplied to the chamber 12c. In addition, in the timing chart related to supply of a radio frequency wave in FIG. 5, the high level (in the diagram, the level indicated by "H") indicates that the first radio frequency wave and the second radio frequency wave are supplied, and the low level (in the diagram, the level indicated by "L") indicates that the first radio frequency wave and the second radio frequency wave are stopped being supplied. FIGS. 6 and 7 are partially enlarged cross-sectional views of workpieces obtained during execution of the method illustrated in FIG. 1. FIG. 8 is a partially enlarged cross-sectional view of a workpiece obtained by executing the method illustrated in FIG. 1.

Steps ST1 to ST3 of the method MT1 are performed in a state where the workpiece W is placed on the stage 16 in the chamber 12c of the plasma processing apparatus 10. In Step ST1 of the method MT1, the first gas is supplied to the chamber 12c. The first gas is gas causing capillary condensation thereof in the porous film PL. In one embodiment, the first gas is a gas consisting of perfluorotetraglyme (hereinafter, will be sometimes referred to as "perfluorotetraglyme gas"). In Step ST1, an inert gas such as a rare gas may be supplied to the chamber 12c, together with the first gas. The rare gas can be an arbitrary rare gas such as He gas, Ne gas, Ar gas, and Kr gas. As illustrated in FIG. 5, in Step ST1, the first radio frequency wave and the second radio frequency wave are stopped being supplied. That is, in Step ST1, plasma is not generated in the chamber 12c.

In Step ST1, partial pressure of the first gas in the chamber 12c, or pressure of the first gas in the chamber 12c when only the first gas is supplied to the chamber 12c is higher than critical pressure causing capillary condensation of the first gas in the porous film PL and lower than saturated vapor pressure of the first gas, at the temperature of the workpiece W during execution of Step ST1. When the partial pressure of the first gas in the chamber 12c, or the pressure of the first gas in the chamber 12c when only the first gas is supplied to the chamber 12c is equal to or higher than the critical pressure, capillary condensation of the first gas is caused in the porous film PL.

In Step ST1, the temperature of the workpiece W is set to a temperature which is lower than a normal temperature (25°C) and is equal to or higher than a lower limit temperature, for example, -60°C that can be set by the above-described refrigerant. In Step ST1 of one embodiment, the temperature of the workpiece W is set to a temperature not less than -50°C and not more than -30°C, for example, -40°C. The temperature of the workpiece W is adjusted by the refrigerant supplied to the stage 16. The temperature of the workpiece W may be substantially the same temperature as the temperature of the stage 16. In Step ST1 of one embodiment, the partial pressure of the first gas in the chamber 12c, or the pressure of the first gas in the chamber 12c when only the first gas is supplied to the chamber 12c is set to pressure not less than 3 mTorr (0.4 Pa) and not more than 10 mTorr (1.333 Pa) in a case where the set temperature of the workpiece W is -40°C. In Step ST1 of one embodiment, the total pressure of gas in the chamber 12c is set to, for example, pressure not less than 11 mTorr (1.47 Pa) and not more than 23 mTorr (3.07 Pa).

In Step ST1, capillary condensation of the first gas is caused in the porous film PL, and the first gas is liquefied in the porous film PL. As a result, as illustrated in FIG. 6, a region SR is formed in the porous film PL. Within the region SR, the pores of the porous film PL are filled with liquid generated from the first gas.

As illustrated in FIG. 1, in the method MT1, subsequently, Step ST2 is performed. In Step ST2, the second gas is supplied to the chamber 12c. That is, in Step ST2, in regard to gas in the chamber 12c, the second gas replaces the first gas. The second gas includes a fluorine-containing gas. The fluorine-containing gas included in the second gas may be a gas such as $NF_3$ gas (nitrogen trifluoride gas), $SiF_4$ gas, and $CF_4$ gas, or a mixed gas of two or more of these gases. The second gas may further include an inert gas such as a rare gas. The rare gas may be an arbitrary rare gas such as He gas, Ne gas, Ar gas, and Kr gas. The second gas may further include an oxygen-containing gas such as $O_2$ gas.

In Step ST2, as illustrated in FIG. 5, the first radio frequency wave and the second radio frequency wave are stopped being supplied. That is, in Step ST2, plasma is not generated. In Step ST2, the pressure of the chamber 12c is set to predetermined pressure. The predetermined pressure is pressure same as the pressure of the chamber 12c while Step ST3 is performed. In addition, in Step ST2, the temperature of the workpiece W is set to a temperature same as the temperature of the workpiece W while Step ST3 is performed, for example, a temperature not less than -50°C and not more than -30°C. The temperature of the workpiece W is adjusted by the refrigerant supplied to the stage 16. The temperature of the workpiece W may be substantially the same temperature as the temperature of the stage 16.

In the method MT1, subsequently, Step ST3 is performed. In Step ST3, plasma of the second gas is generated in the chamber 12c. From Step ST2, the second gas is continuously supplied to the chamber 12c in Step ST3, as illustrated in FIG. 5. In addition, in Step ST3, the first radio frequency wave is supplied to the upper electrode 30, and the second radio frequency wave is supplied to the lower electrode 18. In Step ST3, the second radio frequency wave does not have to be supplied.

In Step ST3, the pressure of the chamber 12c is set to predetermined pressure. The predetermined pressure is pressure of 300 mTorr (40 Pa) or lower, for example. The predetermined pressure may be pressure of 100 mTorr (13.33 Pa) or lower. In Step ST3, the temperature of the workpiece W is set to a temperature not less than -50°C and not more than -30°C, for example. The temperature of the workpiece W is adjusted by the refrigerant supplied to the stage 16. In Step ST3, since a heat input to the workpiece W from plasma is caused, the temperature of the workpiece W becomes slightly higher than the temperature of the stage 16.

In Step ST3, the porous film PL is etched due to the active species, for example, radical. Accordingly, as illustrated in FIG. 7, the porous film PL is etched in a portion exposed from the mask MK. As illustrated in FIG. 7, in Step ST3, the porous film PL is etched within the region SR from the surface thereof.

In the method MT1, in the succeeding Step ST4, it is determined whether or not stopping condition is satisfied. The stopping condition is determined to be satisfied when the number of times of executing a sequence including Steps ST1 to ST3 reaches a predetermined number of times. In Step ST4, when it is determined that the stopping condition is not satisfied, Step ST1 is performed again. That is, in the method MT1, Steps ST1 and ST3 are alternately repeated. Meanwhile, in Step ST4, when it is determined that the stopping condition is satisfied, execution of the sequence including Steps ST1 to ST3 ends. Thereafter, the workpiece W is transferred from the plasma processing apparatus 10 to the heat treatment apparatus via the transfer module TF.

In the method MT1, subsequently, Step ST5 is executed. In Step ST5, the liquid based on the first gas in the porous film PL is removed. In Step ST5, the workpiece W is heated by the heat treatment apparatus such that pressure of the liquid becomes lower than the critical pressure under a vacuumed environment. In Step ST5, the temperature of the workpiece is set to a temperature equal to the normal temperature (25°C) or higher. In Step ST5, the liquid remaining in the porous film PL is vaporized as the workpiece W is heated, and gas generated from the liquid is discharged. When execution of Step ST5 ends, as illustrated in FIG. 8, the workpiece W is in a state of being etched to a surface of the underlying layer UL.

Here, a time $T_1$ required to fill the porous film PL with liquid generated from the first gas will be discussed. The number of moles $M_A$ per unit area required to fill the porous film PL with the liquid is expressed by the following Expression (1). In Expression (1), $T_{PL}$ is the film thickness of the porous film PL, $\rho_{pore}$ is the porosity of the porous film PL per unit area, and $V_m$ is the molar volume of the liquid formed from the first gas.

$$M_A = \frac{T_{PL} \times \rho_{pore}}{V_m} \qquad \cdots (1)$$

In addition, the number of moles $M_B$ of gas molecules incident on a plane per unit time is expressed by the following Expression (2). In Expression (2), $P_1$ is the partial pressure of the first gas in the chamber, or the pressure of the first gas in a case where only the first gas is supplied to the chamber. In Expression (2), m is the mass of molecules of the first gas, $k_B$ is a Boltzmann's constant, $T_{gas}$ is the temperature of the first gas, and $N_A$ is an Avogadro's number.

$$M_B = \frac{P_1}{\sqrt{2\pi m k_B T_{gas}}} \div N_A \qquad \cdots (2)$$

The time $T_1$ can be obtained by dividing the number of moles $M_A$ per unit area required to fill the porous film PL with the liquid by the number of moles $M_B$ of gas molecules incident on a plane per unit time and is therefore expressed by the following Expression (3).

$$T_1 = M_A \div M_B = \frac{T_{PL} \times \rho_{pore}}{V_m} \div \left( \frac{P_1}{\sqrt{2\pi m k_B T_{gas}}} \div N_A \right) \qquad \cdots (3)$$

When the first gas is perfluorotetraglyme gas, and $T_{PL}$, $\rho_{pore}$, $P_1$, and $T_{gas}$ are respectively 100 nm, 0.4, 2 mTorr, and 20°C, the time $T_1$ becomes 400 milliseconds. Thus, in an example, the execution time of Step ST1 can be set to 400 milliseconds or longer. In addition, the sum of the execution time of Step ST2 and the execution time of Step ST3 is set so as not to exceed the time during which the liquid generated from the first gas is retained in the porous film PL.

As described above, in the method MT1, the first gas, that is, the perfluorotetraglyme gas is used in Step ST1. The saturated vapor pressure of the first gas is considerably larger than the critical pressure causing capillary condensation of the first gas in the porous film PL. That is, the difference between the saturated vapor pressure of the first gas and the critical pressure causing capillary condensation of the first gas in the porous film PL is remarkably significant. Therefore, when the first gas is condensed in the porous film PL and becomes liquid, under the temperature of the stage 16 in the above-described Steps ST2 and ST3, and the pressure of gas in the chamber 12c, the liquid is retained in the porous film PL for a comparatively long time. Thus, in the method MT1, the execution times of Steps ST2 and ST3 can be ensured for a long time. As a result, according to the method MT1, a throughput of etching the porous film PL is improved. In addition, perfluorotetraglyme is a molecule including a comparatively large number of oxygen atoms. Accordingly, during etching, fragments containing oxygen are generated, but a simple substance of an oxygen atom (oxygen radical) is restrained from being generated. Therefore, the quantity of reaction products containing carbon generated through etching can be reduced, without supplying a large quantity of oxygen gas or the like. Thus, damage of the porous film PL is reduced. In addition, since the quantity of a reaction product is reduced, the verticality of the opening formed in the porous film PL by etching is enhanced.

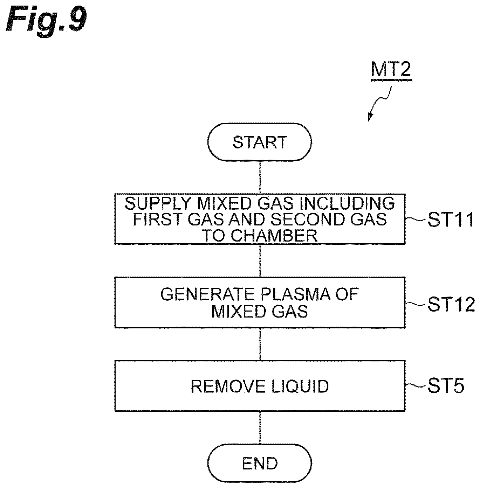

Hereinafter, a method of etching a porous film according to another embodiment will be described. FIG. 9 is a flow chart illustrating the method of etching a porous film according to another embodiment. A method MT2 illustrated in FIG. 9 is executed in order to etch the porous film PL while the porous film PL is protected by the liquid generated from the first gas, similar to the method MT1. Hereinafter, the method MT2 will be described in connection with a case where the method MT2 is applied to the workpiece W, using the processing system 1 having the plasma processing apparatus 10 as one process module. However, the method MT2 can be performed by using an arbitrary plasma processing apparatus or an arbitrary processing system. In addition, the method MT2 can be applied to an arbitrary workpiece having a porous film.

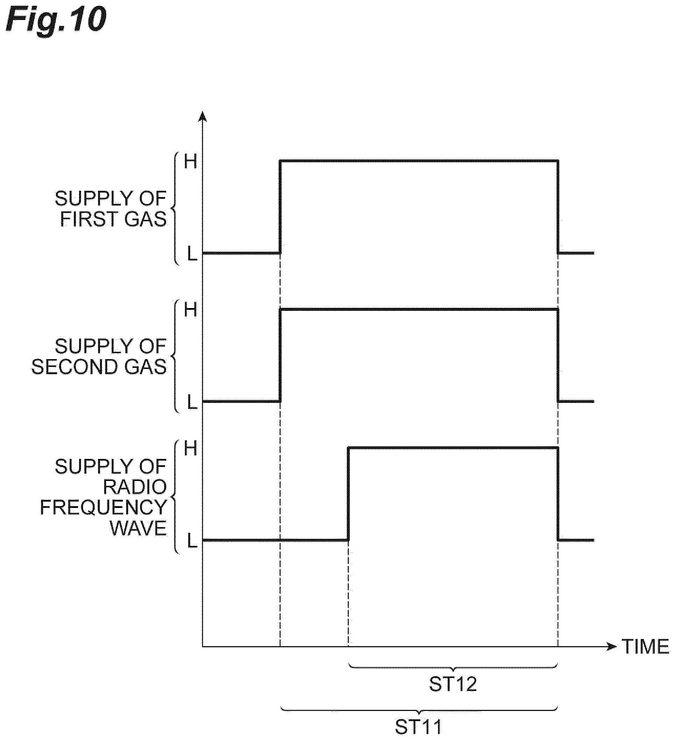

The following description will be given with reference to FIG. 10, in addition to FIG. 9. FIG. 10 is a timing chart related to the method illustrated in FIG. 9. In FIG. 10, the horizontal axis indicates the time. In the timing chart related to supply of the first gas in FIG. 10, a high level (in the diagram, the level indicated by "H") indicates that the first gas is supplied to the chamber 12c, and a low level (in the diagram, the level indicated by "L") indicates that the first gas is not supplied to the chamber 12c. In addition, in the timing chart related to supply of the second gas in FIG. 10, the high level (in the diagram, the level indicated by "H") indicates that the second gas is supplied to the chamber 12c, and the low level (in the diagram, the level indicated by "L") indicates that the second gas is not supplied to the chamber 12c. In addition, in the timing chart related to supply of a radio frequency wave in FIG. 10, the high level (in the diagram, the level indicated by "H") indicates that the first radio frequency wave and the second radio frequency wave are supplied in order to generate plasma and to attract ion, and the low level (in the diagram, the level indicated by "L") indicates that the first radio frequency wave and the second radio frequency wave are stopped being supplied.

Steps ST11 and ST12 of the method MT2 are executed in a state where the workpiece W is placed on the stage 16 in the chamber 12c of the plasma processing apparatus 10. In Step ST11 of the method MT2, the first gas is supplied to the chamber 12c. The first gas is a gas same as the first gas used in the method MT1. In Step ST11, in addition to the first gas, the second gas is also supplied to the chamber 12c. The second gas is a gas same as the second gas used in the method MT2. That is, in Step ST11, a mixed gas including the first gas and the second gas is supplied to the chamber 12c. As illustrated in FIG. 10, during the time period from the start time point of Step ST11 and to the start time point of Step ST12, the first radio frequency wave and the second radio frequency wave are stopped being supplied. That is, plasma is not generated during the time period from the start time point of Step ST11 and to the start time point of Step ST12.

In the succeeding Step ST12, plasma of the mixed gas including the first gas and the second gas is generated in the chamber 12c in order to etch the porous film PL. As illustrated in FIG. 10, Step ST12 starts at the time point between the start time point and the end time point of Step ST11. That is, supply of the first radio frequency wave and the second radio frequency wave is started from the time point between the start time point and the end time point of Step ST11, and the supply of the first radio frequency wave and the second radio frequency wave continues until the common end time point of Steps ST11 and ST12.

In Step ST12 of the embodiment, power of at least one of the first radio frequency wave and the second radio frequency wave is increased and decreased alternately. For example, in Step ST12, ON and OFF of at least one of the first radio frequency wave and the second radio frequency wave are switched alternately. In a case where the first radio frequency wave is ON, the first radio frequency wave is supplied to the upper electrode 30 (or the lower electrode 18), and in a case where the first radio frequency wave is OFF, the first radio frequency wave is stopped being supplied to the upper electrode 30 (or the lower electrode 18). In addition, in a case where the second radio frequency wave is ON, the second radio frequency wave is supplied to the lower electrode 18, and in a case where the second radio frequency wave is OFF, the second radio frequency wave is stopped being supplied to the lower electrode 18. Hereinafter, a radio frequency wave of which power is increased and decreased alternately, and a radio frequency wav of which ON/OFF is switched alternately are sometimes referred to as "pulse wave".

In Steps ST11 and ST12, the temperature of the workpiece W is set to -60°C or higher and a temperature lower than the normal temperature (25°C). For example, in Steps ST11 and ST12, the temperature of the workpiece W is set to a temperature not less than -50°C and not more than -30°C. The temperature of the workpiece W is adjusted by the refrigerant supplied to the stage 16. In addition, in Steps ST11 and ST12, the partial pressure of the first gas in the chamber 12c is set to 0.4 Pa (3 mTorr) or higher, and the total pressure of gas inside the chamber 12c is set to 3.333 Pa (25 mTorr) or lower.

As illustrated in FIG. 9, in the method MT2, subsequently to Step ST12, Step ST5 is executed. Step ST5 in the method MT2 is a step same as Step ST5 in the method MT1.

According to the method MT2, similar to the method MT1, the first gas is liquefied in the porous film PL, and liquid is generated in the porous film PL. The generated liquid is retained in the porous film PL for a comparatively long time. In addition, in the method MT2, since the first gas is supplied to the chamber 12c while Step ST12 is executed, that is, even while plasma etching is executed, liquid protecting the porous film PL is supplemented while Step ST12 is executed. According to the method MT2, damage of the porous film PL can be reduced, and a throughput of etching the porous film PL is improved. In addition, the verticality of the opening formed in the porous film PL by etching is enhanced.

In addition, in Step ST12 of the embodiment, power of at least one of the first radio frequency wave and the second radio frequency wave is increased and decreased alternately. Accordingly, the quantity of deposits (reaction products containing carbon) in the vicinity of the upper end of the opening formed in the porous film PL is reduced. As a result, the verticality of the opening formed in the porous film PL by etching is further improved.

Hereinafter, a description will be given regarding a first experiment in which a time during which liquid generated from perfluorotetraglyme gas is retained in the porous film was examined. In the first experiment, the workpiece having a porous film was placed on the stage 16 in the chamber 12c, and the temperature of the workpiece was set to various temperatures. Then, a mixed gas of the perfluorotetraglyme gas and $SF_6$ gas was supplied to the chamber 12c. The porous film was a SiOCH film having the relative dielectric constant of 2.2. In addition, the pressure of the mixed gas was 22.5 mTorr (3 Pa), and the partial pressure of the perfluorotetraglyme gas was 2.65 mTorr (0.35 Pa). After the porous film was filled with the liquid generated from perfluorotetraglyme gas, the workpiece was disposed under a vacuumed environment, and a chronological change of the refractive index of the porous film under environments at various temperatures was acquired through an ellipsometry method. It should be noted that the refractive index of the porous film decreases as the quantity of the liquid in the porous film decreases.

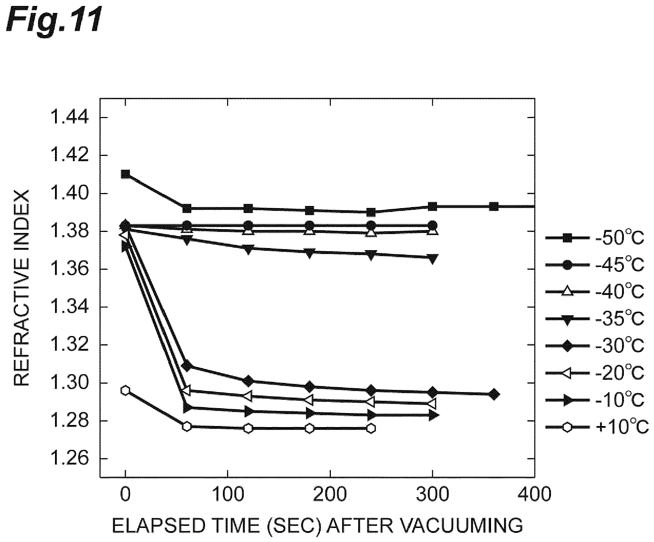

FIG. 11 illustrates a chronological change of the refractive index of the porous film acquired in the first experiment. In FIG. 11, the horizontal axis indicates the elapsed time after vacuuming starts, and the vertical axis indicates the refractive index of the porous film. As illustrated in FIG. 11, in a case where the temperature of the workpiece after start of vacuuming was set to a temperature of -35°C or lower, the refractive index of the porous film was retained at a high value for several minutes. That is, in a case where the temperature of the workpiece after start of vacuuming was set to a temperature of -35°C or lower, the liquid was retained in the porous film for several minutes. In addition, even in a case where the temperature of the workpiece after start of vacuuming was set to -30°C, it was confirmed that the liquid was retained in the porous film for approximately ten seconds. Therefore, it was confirmed that the liquid is able to be retained in the porous film PL for a long time, in a case where the perfluorotetraglyme gas is used as the first gas, when the temperature of the workpiece W is set to a temperature of -30°C or lower or a temperature of -35°C or lower in Steps ST2, ST3, and ST12.

Hereinafter, a description will be given regarding a second experiment performed for an evaluation of the method MT2. In the second experiment, the method MT2 was performed by using the processing system 1 having the plasma processing apparatus 10, thereby etching porous films of a plurality of workpieces each having the structure illustrated in FIG. 2. Each of the porous films was a SiOCH film having the relative dielectric constant of 2.2 and the film thickness of 100 nm. The film thickness of a mask of each of the workpieces was 20 nm, and the pattern of the mask was a line-and-space pattern having line portions of 22 nm and spaces of 22 nm. In the second experiment, the partial pressure of the first gas during execution of Steps ST11 and ST12 with respect to the plurality of workpieces was varied as indicated in (2-1) to (2-3) below. Hereinafter, conditions of the second experiment will be shown.

<Conditions of Steps ST11 and ST12 in Second Experiment>

First gas in mixed gas: perfluorotetraglyme gas
Second gas in mixed gas: $NF_3$ gas
Partial pressure of first gas

    (2-1) 2.8 mTorr (0.37 Pa),
    (2-2) 4.8 mTorr (0.64 Pa), and
    (2-3) 6.8 mTorr (0.91 Pa)

Total pressure of gas in chamber 12c: 23 mTorr (3.07 Pa)
Temperature of workpiece: -40°C
Execution time of Step ST11: 170 (sec)
Time difference between start time point of Step ST11 and start time point of Step ST12: 60 seconds
First radio frequency wave in Step ST12: continuous wave of 27 MHz, 100 W
Second radio frequency wave in Step ST12: continuous wave of 400 kHz, 50 W
Execution time of Step ST12: 110 (sec)

<Conditions of Step ST5 in Second Experiment>

Temperature of workpiece: 60°C
Processing time: 120 seconds
Pressure of chamber of heat treatment apparatus: vacuumed state, 0.1 mTorr or lower (0.013 Pa or lower)

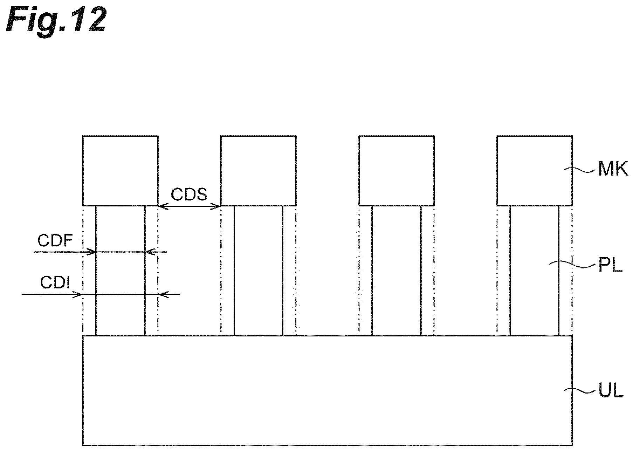

In the second experiment, a line width CDI of the porous film PL of each of the workpieces immediately after execution of the method MT2, and a line width CDF of the porous film PL after each of the workpieces was subjected to hydrofluoric treatment immediately after execution of the method MT2 were measured (refer to FIG. 12), and the difference between the width CDI and the width CDF of the porous film PL of each of the workpieces, that is, CDI-CDF was obtained. A region in the porous film damaged by the radical at the time of plasma etching is removed by using a hydrofluoric solution. Therefore, the CDI-CDF can be utilized as a scale of damage to the porous film by plasma etching in the method MT2. As a result of the second experiment, the values of the CDI-CDF when the partial pressure of the first gas were set to the above-described conditions (2-1) to (2-3) were 5.3 nm, 4.0 nm, and 4.0 nm, respectively. The values of the CDI-CDF were extremely small values. Therefore, it was confirmed that the porous film is able to be etched by the method MT2 while the porous film is protected from the radical.

Hereinafter, a description will be given regarding a third experiment performed for an evaluation of the method MT2. In the third experiment, the method MT2 was executed by using the processing system 1 having the plasma processing apparatus 10, thereby etching porous films of a plurality of workpieces each having the structure illustrated in FIG. 2. Each of the porous film was a SiOCH film having the relative dielectric constant of 2.2 and the film thickness of 100 nm. The film thickness of a mask of each of the workpieces was 20 nm, and the pattern of the mask was a line-and-space pattern having line portions of 22 nm and spaces of 22 nm. In the third experiment, the type of the second radio frequency wave during execution of Step ST12 with respect to the plurality of workpieces was varied as indicated in (3-1) to (3-4) below. Hereinafter, conditions of the third experiment will be shown.

<Conditions of Steps ST11 and ST12 in Third Experiment>

First gas in mixed gas: perfluorotetraglyme gas
Second gas in mixed gas: $NF_3$ gas
Partial pressure of first gas: 4.8 mTorr (0.64 Pa)
Total pressure of gas in chamber 12c: 23 mTorr (3.07 Pa)

Temperature of the workpiece: -40°C
Execution time of Step ST11: 260 (sec)
Time difference between start time point of Step ST11 and start time point of Step ST12: 60 seconds
First radio frequency wave in Step ST12: continuous wave of 27 MHz, 30 W

Second radio frequency wave in Step ST12: 400 kHz, 100 W

(3-1) continuous wave
(3-2) pulse wave (pulse frequency of 100 Hz, on-duty of 50%)
(3-3) pulse wave (pulse frequency of 100 Hz, on-duty of 20%)
(3-4) pulse wave (pulse frequency of 100 Hz, on-duty of 10%)

Execution time of Step ST12: 200 (sec)

<Conditions of Step ST5 in Third Experiment>

Temperature of workpiece: 60°C
Processing time: 120 seconds
Pressure of chamber of heat treatment apparatus: vacuumed state, 0.1 mTorr or lower (0.013 Pa or lower)

In the third experiment, a width CDS in the vicinity of the upper end of the opening formed in each of the porous films PL (refer to FIG. 12) was measured. As a result, the values of the CDS when the types of the second radio frequency wave was set to the above-described types (3-1) to (3-4) were 22.48 nm, 26.45 nm, 27.78 nm, and 27.76 nm, respectively. From the third experiment, it was confirmed that the width in the vicinity of the upper end of the opening formed in the porous film PL becomes large in a case where the second radio frequency wave is a pulse wave,. Therefore, it was confirmed that the quantity of reaction products in the vicinity of the upper end of the opening formed in the porous film PL is reduced in a case where the second radio frequency is a pulse wave.

Various types of the embodiments have been described. However, various modifications may be made without being limited to the above-described embodiments. For example, the plasma processing apparatus which can be used for performing the method MT1 and the method MT2 is not limited to a capacitive coupling-type plasma processing apparatus. In performing the method MT1 and the method MT2, it is possible to use an arbitrary type plasma processing apparatus such as an inductive coupling-type plasma processing apparatus and a plasma processing apparatus using surface waves such as microwaves for generating plasma.

In addition, in the above-described embodiment, the first gas was the perfluorotetraglyme gas. However, the first gas may be gas other than the perfluorotetraglyme gas. Hereinafter, there will be provided a description regarding several requirements desired for the gas utilized as the first gas to satisfy. Prior to the description, first, various types of numerical values obtained through the experiments will be described.

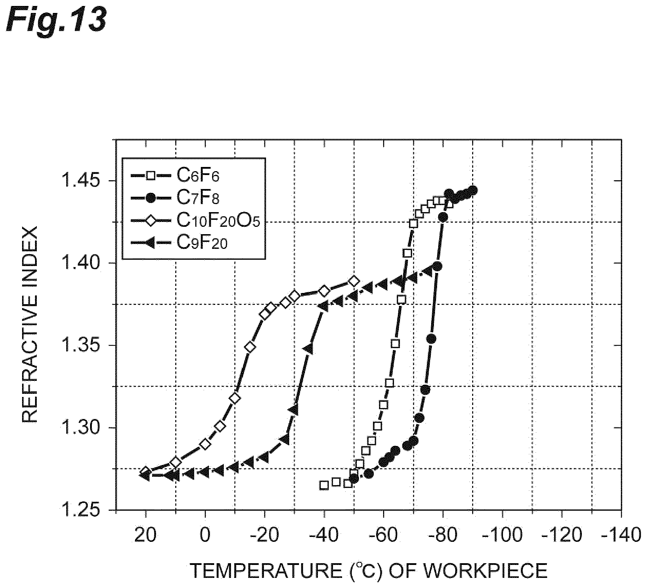

In the experiments, the critical temperature and the critical pressure of each of $C_6F_6$ gas, $C_7F_8$ gas, $C_{10}F_{20}O_5$ gas (perfluorotetraglyme gas), and $C_9F_{20}$ gas causing capillary condensation in the porous film were obtained. In the experiments, while each of the gases was supplied to the porous film, the relationship between the temperature of the porous film and the refractive index of the porous film was obtained by the ellipsometry method. As the porous film, a SiOCH film having the relative dielectric constant of 2.2 was used. In the experiments, the pressure of each of $C_6F_6$ gas and $C_7F_8$ gas was set to 7.5 mTorr (1 Pa), and the pressure of each of $C_{10}F_{20}O_5$ gas and $C_9F_{20}$ gas was set to 3 mTorr (4 Pa). The relationship between the temperature of the porous film and the refractive index of the porous film obtained through the experiments is illustrated in FIG. 13. In the experiments, the pressure set for each of the gases was used as the critical pressure. From the graph illustrated in FIG. 13, the temperature of the porous film corresponding to a middle value of the refractive index of a section in which the refractive index of the porous film rapidly changes was obtained as the critical temperature.

In addition, the contact angle with respect to a plane of each of $C_6F_6$ gas, $C_7F_8$ gas, $C_{10}F_{20}O_5$ gas, and $C_9F_{20}$ gas at the normal temperature (25°C) was obtained. Moreover, capillary condensation of each of $C_6F_6$ gas, $C_7F_8$ gas, $C_{10}F_{20}O_5$ gas, and $C_9F_{20}$ gas was caused in the porous film, and the time during which the liquid was retained in the porous film (hereinafter, will be referred to as "retaining time") under a vacuumed environment was obtained from the refractive index of the porous film measured by using the ellipsometry method.

In regard to the gases, the critical temperature and critical pressure $P_C$ causing capillary condensation, saturated vapor pressure $P_S$ at the critical temperature, $P_C/P_S$, the contact angle at the normal temperature, the molecular weight, and the retaining time are shown in Table 1.

[Table 1]

| | $C_6F_6$ | $C_7F_8$ | $C_{10}F_2O_5$ | $C_9F_{20}$ |
|---|---|---|---|---|
| Critical temperature (°C) causing capillary condensation | -63 | -77 | -10 | -35 |
| Critical pressure $P_C$ (mTorr) causing capillary condensation | 7.5 | 7.5 | 3 | 3 |
| Saturated vapor pressure $P_S$ (mTorr) at critical temperature causing capillary condensation | 150 | 3.6 | 300 | 300 |
| $P_C/P_S$ | 0.05 | 2.08 | 0.01 | 0.01 |
| Contact angle (°) at normal temperature (25°C) | 8 | 12 | <5 | <5 |
| Molecular weight | 186 | 205 | 618 | 488 |
| Retaining time | to several seconds | -- | several minutes or longer | several minutes or longer |

Hereinafter, with reference to Table 1, a description will be given regarding several requirements desired for the gas utilized as the first gas to satisfy.

A first requirement is one that a gas utilized as the first gas consists of molecules having the composition of $C_xF_yO_z$. Here, x and y are integers of 1 or greater, and z is an integer of zero or greater.

A second requirement is one that a gas utilized as the first gas causes capillary condensation at a temperature of -60°C or higher. When the second requirement is satisfied, an ordinary refrigerant which is comparatively inexpensive can be used as the refrigerant to be supplied to the stage 16.

A third requirement is one that a gas utilized as the first gas has saturated vapor pressure of 1 Torr (133.3 Pa) or higher at the normal temperature (25°C). When the third requirement is satisfied, the liquid in the porous film can be vaporized at a temperature equal to or higher than the normal temperature and can be discharged.

A fourth requirement is one that a gas utilized as the first gas has a significant difference between the saturated vapor pressure $P_S$ and the critical pressure $P_C$, that is, to have small $P_C/P_S$. For example, when $P_C/P_S$ of the gas is 0.05 or smaller, or 0.01 or smaller, the gas can satisfy the fourth requirement.

$P_C/P_S$ is theoretically expressed by the following Expression (4), that is, Kelvin's expression. In Expression (4), $V_m$ is the molar volume of the liquid in the porous film, $\gamma$ is the surface tension of the liquid, R is the gas constant, T is the absolute temperature of the porous film, r is the radius of the empty pore in the porous film, and $\theta$ is the contact angle between the liquid and the porous film.

$$\ln\left(\frac{P_C}{P_S}\right) = -\frac{2V_m\gamma}{RTr}\cos\theta \qquad \cdots(4)$$

As is clear with reference to Expression (4) and Table 1, $P_C/P_S$ has a correlation with the contact angle $\theta$. The contact angle $\theta$ of the liquid generated from the perfluorotetraglyme gas, that is, $C_{10}F_{20}O_5$ gas is 5° or smaller, as indicated in Table 1. Therefore, a requirement that the contact angle of the liquid generated from a gas utilized as the first gas with respect to the porous film is 5° or smaller can be set as a fifth requirement.

A sixth requirement is one that a gas utilized as the first gas has a ratio of the number of atoms of oxygen to the number of atoms of carbon in molecules is 0.5 or greater. When the sixth requirement is satisfied, damage the porous film is reduced, and the quantity of reaction products containing carbon generated through etching is reduced.

A seventh requirement is one that the time during which the liquid generated from a gas utilized as the first gas is retained in the porous film is long. The volatilization rate $f_e$ of the liquid in the porous film is expressed by the following Expression (5). In Expression (5), $P_v$ is the critical pressure causing capillary condensation of the gas, m is the molecular weight of molecules configuring the gas, k is a Boltzmann's constant, and T is the absolute temperature of the porous film.

$$f_e = \frac{P_v}{\sqrt{2\pi mkT}} \qquad \cdots(5)$$

As is able to be understood from Expression (5), the volatilization rate $f_e$ of the liquid in the porous film decreases as the molecular weight of molecules configuring the gas increases. That is, as the molecular weight of molecules configuring the gas increases, the liquid generated from the gas is retained in the porous film for a long time. The retaining time of the liquid generated from the first gas is required to be longer than the retaining time of the liquid based on $C_6F_6$ gas. Therefore, the seventh requirement may be one that the molecular weight of molecules configuring the gas utilized as the first gas is greater than the molecular weight of $C_6F_6$, that is, 186. In addition, since the liquid based on $C_9F_{20}$ gas is retained in the porous film for several minutes or longer, the seventh requirement may be one that the molecular weight of molecules configuring the gas utilized as the first gas is 488 or greater.

A gas utilized as the first gas is selected from gas that satisfies the above-described first to seventh requirements among gases consisting of molecules having the composition of $C_xF_yO_z$. The composition satisfies $6 \leq x \leq 22$, more desirably satisfies $8 \leq x \leq 12$ and $0 \leq z \leq 10$, further more desirably satisfies $4 \leq z \leq 6$ and $2x-2 \leq y \leq 2x+2$, and still more desirably satisfies $y=2x+2$.

Reference Signs List

1: processing system, TF: transfer module, 10: plasma processing apparatus, 12c: chamber, 16: stage, 18: lower electrode, 20: electrostatic chuck, 50: gas discharging apparatus, 62: first radio frequency power source, 64: second radio frequency power source, W: workpiece, MK: mask, PL: porous film, MT1 and MT2: method

**Claims**

1. A method of etching a porous film, wherein the method is performed in a state where a workpiece having the porous film and a mask provided on the porous film and providing an opening exposing the porous film partially is placed on a stage provided in a chamber of a plasma processing apparatus, the method comprising:

   supplying a first gas to the chamber, the first gas being gas consisting of perfluorotetraglyme; and
   generating plasma of a second gas for etching of the porous film, to etch the porous film at the same time as said supplying a first gas or after said supplying a first gas, and
   wherein partial pressure of the first gas in the chamber or pressure of the first gas in the chamber when only the first gas is supplied to the chamber is higher than critical pressure causing capillary condensation of the first gas in the porous film and lower than saturated vapor pressure of the first gas at a temperature of the workpiece during execution of said supplying a first gas.

2. The method according to Claim 1,
   wherein in said supplying a first gas, a mixed gas including the first gas and the second gas is supplied to the chamber, and
   wherein in said generating plasma of a second gas, plasma of the mixed gas is generated in the chamber.

3. The method according to Claim 2,
   wherein in said supplying a first gas and said generating plasma of a second gas, the temperature of the workpiece is set to a temperature not less than -50°C and not more than -30°C, the partial pressure of the first gas is set to 0.4 Pa or higher, and total pressure of gas in the chamber is set to 3.333 Pa or lower.

4. The method according to Claim 2 or 3,
   wherein in said generating plasma of a second gas, a power of at least one of a first radio frequency wave for generating the plasma and a second radio frequency wave for attracting ion to the workpiece is increased and decreased alternately.

5. The method according to Claim 1,
   wherein said supplying a first gas and said generating plasma of a second gas are alternately performed, and
   wherein the method further comprises supplying the second gas to the chamber without generating plasma, between said supplying a first gas and said generating plasma of a second gas.

6. The method according to Claim 5,
   wherein in said supplying a first gas and said generating plasma of a second gas, the temperature of the workpiece is set to a temperature not less than -50°C and not more than -30°C, and
   wherein in said supplying a first gas, the partial pressure of the first gas in the chamber or the pressure of the first gas in the chamber when only the first gas is supplied to the chamber is set to 0.4 Pa or higher.

7. The method according to any one of Claims 1 to 6, further comprising removing liquid in the porous film generated from the first gas, after the porous film is etched
wherein in said removing liquid, the workpiece is heated such that pressure of the liquid becomes lower than the critical pressure under a vacuumed environment.

8. The method according to any one of Claims 1 to 7,
wherein the porous film is a low-dielectric constant film containing silicon, oxygen, carbon, and hydrogen.

9. The method according to Claim 8,
wherein the second gas includes nitrogen trifluoride gas.

# Fig.1

MT1

START

SUPPLY FIRST GAS
TO CHAMBER — ST1

SUPPLY SECOND GAS
TO CHAMBER — ST2

GENERATE PLASMA
OF SECOND GAS — ST3

ST4

NO          IS STOPPING
CONDITION SATISFIED?

YES

REMOVE LIQUID — ST5

END

Fig.2

*Fig.3*

# *Fig.4*

# Fig.5

*Fig.6*

# Fig.7

*Fig.8*

# Fig.9

MT2

START

SUPPLY MIXED GAS INCLUDING
FIRST GAS AND SECOND GAS
TO CHAMBER ~ST11

GENERATE PLASMA OF
MIXED GAS ~ST12

REMOVE LIQUID ~ST5

END

## Fig.10

## Fig.11

# Fig.12

## Fig.13

**INTERNATIONAL SEARCH REPORT**

| International application No. |
|---|
| PCT/JP2018/017995 |

A. CLASSIFICATION OF SUBJECT MATTER
Int.Cl. H01L21/3065(2006.01)i, H01L21/768(2006.01)i, H01L23/532(2006.01)i

According to International Patent Classification (IPC) or to both national classification and IPC

B. FIELDS SEARCHED

Minimum documentation searched (classification system followed by classification symbols)
Int.Cl. H01L21/3065, H01L21/768, H01L23/532

Documentation searched other than minimum documentation to the extent that such documents are included in the fields searched
| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2016-207768 A (TOKYO ELECTRON LTD.) 08 December 2016, entire text, all drawings & US 2016/0307732 A1 & EP 3086358 A1 & KR 10-2016-0124678 A & CN 106067410 A & TW 201705272 A | 1–9 |
| A | JP 2016-184725 A (IMEC VZW) 20 October 2016, entire text, all drawings & US 2016/0276133 A1 & EP 3070735 A1 | 1–9 |
| A | JP 2015-61073 A (IMEC VZW) 30 March 2015, entire text, all drawings & US 2015/0076109 A1 & US 8961803 B1 & EP 2849212 A1 & KR 10-2015-0032160 A & TW 201513221 A | 1–9 |

☒ Further documents are listed in the continuation of Box C.   ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27 June 2018 (27.06.2018) | 10 July 2018 (10.07.2018) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

International application No.

PCT/JP2018/017995

C (Continuation).    DOCUMENTS CONSIDERED TO BE RELEVANT

| Category* | Citation of document, with indication, where appropriate, of the relevant passages | Relevant to claim No. |
|---|---|---|
| A | ZHANG, Liping, "Low Damage Cryogenic Etching of Porous, Organosilicate Low-k Materials Using SF6/02/SiF4", ECS Journal of Solid State Science and Technology, 05 April 2013, vol. 2, no. 6, N131-N139 | 1-9 |
| A | JP 2010-4049 A (APPLIED MATERIALS, INC.) 07 January 2010, entire text, all drawings & US 2009/0317971 A1 & KR 10-2009-0133094 A & TW 201009940 A | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016207768 A